# EUROPEAN PATENT SPECIFICATION

(11) **EP 2 907 168 B1**
(45) Date of publication and mention of the grant of the patent: **07.06.2017**
(21) Application number: 13777273.7
(22) Date of filing: 15.10.2013
(51) Int. Cl.: H01L 31/05, H01L 31/052

(54) **CPVLIS - CONCENTRATION PHOTOVOLTAICS LAMINATED INTERCONNECTION SYSTEM COMPRISING A CPV RECEIVER PANEL, A METHOD FOR PREPARING THE CPV RECEIVER PANEL AND AN INSTALLATION COMPRISING THE SAME**
CPVLIS - CONCENTRATION PHOTOVOLTAICS LAMINATED INTERCONNECTION SYSTEM MIT CPV-EMPFÄNGERPLATTE, VERFAHREN ZUR HERSTELLUNG DER CPV-EMPFÄNGERPLATTE UND ANLAGE DAMIT
CPVLIS - SYSTÈME D'INTERCONNEXION STRATIFIÉ POUR PHOTOVOLTAÏQUE SOUS CONCENTRATION (CPV) COMPRENANT UN PANNEAU DE RÉCEPTEURS CPV, PROCÉDÉ DE PRÉPARATION DU PANNEAU DE RÉCEPTEURS CPV, ET INSTALLATION LE COMPRENANT

(30) Priority: 15.10.2012 US 201261714073 P
(43) Date of publication of application: 19.08.2015
(73) Proprietor: Pardell Vilella, Ricard, 08197 Valldoreix (ES)
(72) Inventor: Pardell Vilella, Ricard, 08197 Valldoreix (ES)
(74) Representative: Mohammadian, Dario
(86) International application number: PCT/EP2013/071515
(87) International publication number: WO 2014/060404

(56) References cited:
- WO-A1-2011/081090
- JP-A- 2006 174 668
- US-A1- 2008 123 313
- US-A1- 2008 185 034

## Description

### TECHNICAL FIELD

The present invention relates generally to the field of concentration photovoltaic CPV systems, and in particular, to a CPV receiver panel showing improved properties. The present invention relates also to a method for manufacturing said CPV receiver panel and to an installation comprising said CPV receiver panel.

### BACKGROUND OF THE INVENTION

Typical concentration photovoltaic CPV systems are based on modules comprising a combination of primary refractive optics with high-efficiency photovoltaic cells arranged in a matrix pattern. A CPV module usually comprises a front lens panel and a back panel, wherein each lens in the front panel concentrates the solar radiation on a corresponding photovoltaic cell on the back panel. The back panel must dissipate any excess heat to the environment, acting as a heat sink. In order to constitute the back panel, it is a common practice to first mount the cells on CPV receivers and the receivers on a base plate, herein referred to as CPV receiver panel.

A CPV receiver is a micro-electronic assembly comprising a photovoltaic cell and usually also secondary optics and a bypass diode. The cell is mounted on a suitable substrate providing good electric insulation and low thermal resistance, as a substantial amount of heat must be dissipated from the cell.

As described in the foregoing, it is required that the back panel promotes heat dissipation to the environment. As the receivers are placed at a significant distance from each other, there is the problem that overheating may occur in concentrated spots of the back panel. Hence, it is desirable to help the heat flow expand to the whole back surface area and then to use convection to the outside environment and irradiative cooling mechanisms.

CPV modules are also serially connected between them, in order to maximize system voltage. It is common to aim at maximum allowed DC voltages, as this minimizes Joule losses and copper usage. A high system DC voltage also helps increase inverter (DC/AC conversion) efficiency because a voltage boost stage is avoided, and thus also decreases its cost. It is therefore a common practice to bring system DC voltages up to 600 V in the US and 1000 V in Europe, the maximum allowed. This combination of high DC voltages and a grounded metal back plate is challenging, as receiver interconnections are very close to the aluminium heat sink. Therefore, there is the problem that additionally a dielectric break-down resistance in the order of 3000 V must be assured, because otherwise there exists the risk of damage to the CPV receiver panel.

It is a common feature of other CPV systems that they are properly insulated under dry conditions, but not under wet conditions, assuming that the module inside is always water free. As CPV modules are physically like boxes, containing a significant amount of air, there is the problem that condensations can never be completely discarded, and also accidents may happen which would imply some rain water filtering inside the module. So, in case of wet conditions inside the module, most CPV designs have the problem that they fail to fulfil the electric insulation requirements, therefore posing a significant safety risk. Some systems use active drying systems in order to avoid or get rid of condensations, but these systems may also eventually fail.

Besides losing insulation, for systems relying exclusively on module watertightness and active drying systems, there is the problem that inside materials can degrade after a condensation or water leakage event, degrading long term performance and reliability. Any accident, including for instance an active drying system malfunction, can therefore derive into safety risks and/or system degradation.

Finally, an additional problem lies in the fact that any materials used inside the module, if exposed to the inside surface must be able to withstand highly concentrated radiation. Under normal operation, when solar tracking works properly, all the solar radiation will be focused inside the receiver solar aperture, but it may eventually happen that the solar tracking system is stopped, and it is a requirement that the CPV module can withstand this off-focus situation without any long term damage.

Document US 2008/185034 A1 discloses a compact solar concentrator photovoltaic module assembly including a plurality of small rear contact solar cells configured in a matrix array on a substrate, and a lens sheet disposed in a fixed spaced relation to the substrate and operating to focus sunlight onto the active surfaces of the PV cells. Document US 2008/0123313 A1 discloses a mount for a semiconductor device including a substrate to receive a semiconductor device and a planar element. The planar element has an aperture sized to surround the semiconductor device such that the semiconductor device is aligned by the aperture.

Document US 2012/029185 A1 discloses a concentrating solar battery in which concentrated sunlight is guided to a solar battery cell. The concentrating solar battery has a structure hermetically sealed by the substrate, the light guide member and the support member.

Therefore a need has been identified for a CPV receiver panel that provides long term high electric insulation degree, even under wet conditions, and has good thermal conductivity.

Also, it is an objective of CPV systems to become the most competitive solar conversion technology. This means that a high production volume and low-cost technique is needed. Also, very accurate positioning for receivers is required. Otherwise, there is the problem that the photovoltaic cells cannot be kept in focus.

Therefore, there is also a need for an automated receiver mounting and interconnection process for the manufacture of CPV receiver panels providing an easy and cheap manufacture, and yielding very accurate positioning of the receivers onto the base plate and of the base plate onto the module's structure.

### SUMMARY

It is therefore an object of the present invention to provide solutions to some or all of the above mentioned problems. In accordance with one or more embodiments, and corresponding disclosure thereof, various aspects are described in connection with yielding a completely protected laminated CPV receiver panel, referred herein to as CPVLIS, a CPV Laminated Interconnection System.

One embodiment of the present invention provides an improved receiver panel for a concentration photovoltaics system.

Another embodiment of the present invention provides a method for manufacturing an improved receiver panel for a concentration photovoltaics system.

Yet another embodiment of the present invention provides a concentration photovoltaic system comprising an improved receiver panel.

Yet another embodiment of the present invention provides an installation for manufacturing an improved receiver panel.

Further aspects of the present invention provide methods and devices that implement various aspects, embodiments and features, and are implemented by various means.

### BRIEF DESCRIPTION OF THE DRAWING(S)

The features and advantages of the present invention become more apparent from the detailed description set forth below when taken in conjunction with the drawings in which like reference characters identify corresponding elements in the different drawings. Corresponding elements may also be referenced using different characters.
FIG. 1 depicts a general view of a laminated CPVLIS receiver panel according to one embodiment of the present invention.
FIG. 2 depicts an exploded view of the CPVLIS receiver panel of FIG. 1.
FIGS. 3 to 4 show different stages of the assembly process of the CPVLIS receiver panel of FIG. 1.
FIG. 5 shows a detailed view of a receiver and a connection plate of the CPVLIS receiver panel of FIG. 1.
FIGS. 6 to 7 show further stages of the assembly process of the CPVLIS receiver panel of FIG. 1.
FIG. 8 shows a detailed view of an interconnection between a receiver and a connection plate of the CPVLIS receiver panel of FIG. 1.
FIG. 9 shows a further stage of the assembly process of the CPVLIS receiver panel of FIG. 1
FIG. 10 depicts a cross-sectional view of the CPVLIS receiver panel of FIG. 1.
FIGS. 11 to 12 show details of an alternative process for the assembly of secondary optics of the receiver panel of FIG. 1.

### DETAILED DESCRIPTION OF THE INVENTION

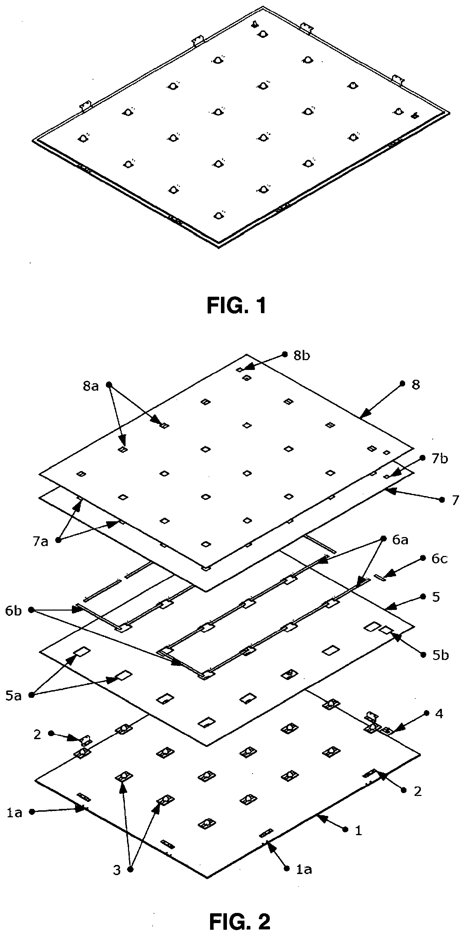

FIG.1 shows a completely protected laminated CPVLIS receiver panel according to one embodiment of the present invention. The receiver panel assures that the insulation requirements are fulfilled both under dry and wet conditions. This means that the receiver panel does not pose any safety risk in case of internal condensation or water leakages. Also, the receiver panel does not deteriorate under wet conditions, being water-tight and all its surfaces water-proof. As a consequence, water is not able to reach the receivers or the interconnectors, the cells remaining completely encapsulated. Therefore, in case of accidental water leaks or occasional condensations, the module performance does not suffer any long term degradation, thus providing a strong foundation for a highly reliable CPV system. Therefore, the CPVLIS receiver panel design of the present invention yields a very compact, reliable, environment protected and mechanically strong product, thereby facilitating its logistics and factory manipulation. Furthermore, the receiver assembly and interconnection processes on the receiver panel may be carried out in an accurate, repeatable and fast manner, so that CPVLIS receiver panels are very easy to mechanically integrate at module and system level. Additionally, the receiver panel of the present invention allows the possibility to integrate secondary options during the lamination process.

FIG. 2 is an exploded view of the laminated CPVLIS receiver panel of FIG. 1. As can be derived from FIG. 2, the laminated CPVLIS receiver panel is composed of several distinct layers 1, 5, 7, and 8, which are piled one over another. CPV receivers 3 and electric connection means 4 are mounted on the base plate 1. Optionally, also fixing means 2, such as mounting brackets, may be provided, which may preferably be fixed in the fixing holes 1a. The layers 5, 7, and 8 are provided with openings corresponding to the positions of the receivers 3 and the electric connection means 4 allowing them to protrude the CPV receiver panel with a portion of their upper part. Between layers 5 and 7, an electric interconnection string 6 is provided interconnecting serially the receivers 3 and the electric connection means 4. In the following, the structure and assembly of the CPV receiver panel are described in more detail.

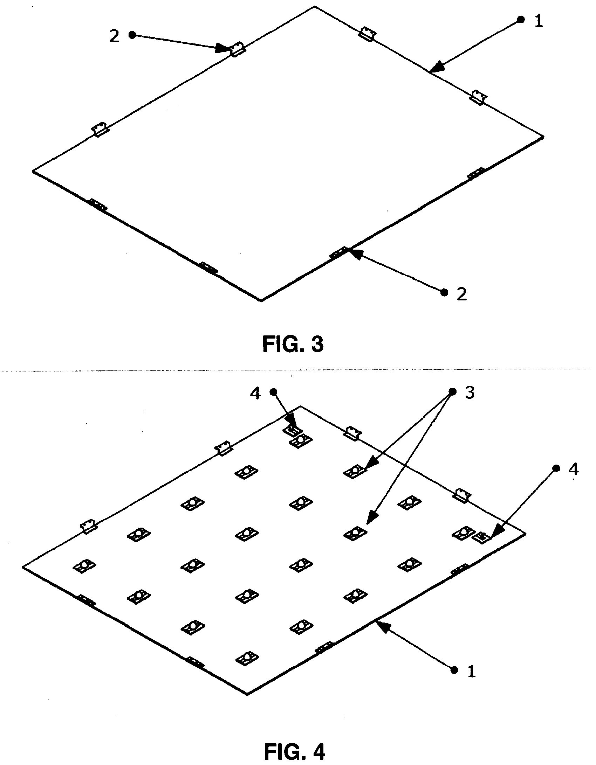

FIG. 3 shows a base plate 1 comprised in the laminated CPVLIS receiver panel. Said base plate 1 is thermally conductive. Hence, the base plate 1 acts at the same time as heat sink and mechanical substrate. This plate must be thick enough to provide the desired stiffness and also to help heat spreading. In one aspect the base plate is for example about 3 mm thick. With its bottom side, the base plate 1 is in contact with the outside environment, and with the module's internal air on its top side. The basic heat dissipation mechanism is through convection to the outside environment air through the bottom side, although a significant contribution comes from radiative cooling. Therefore it will be preferred to carry out a suitable surface treatment which will improve emissivity in the infrared spectra, like anodising or painting the bottom surface. The base plate 1 may be made from aluminium or aluminium alloy offering high thermal conductivity, like AL1050. In one preferred aspect of the present invention, the base plate 1 can have dimensions in the range of 770 mm of length, 620 mm of width, and 3 mm of height.

Mounting reference holes 1a are made on the base plate 1 edges, using tight tolerance positioning methods like laser cutting, CNC punching, CNC drilling or similar. Optional mounting brackets 2 may be later fastened to the base plate 1 through these holes by riveting, bolting, or similar. The receiver panel may be mechanically fastened to the module's body using the reference holes 1a or the optional mounting brackets 2. These holes 1a or the optional mounting brackets 2 are to be used as reference points for subsequent receiver assembly, requiring very accurate positioning.

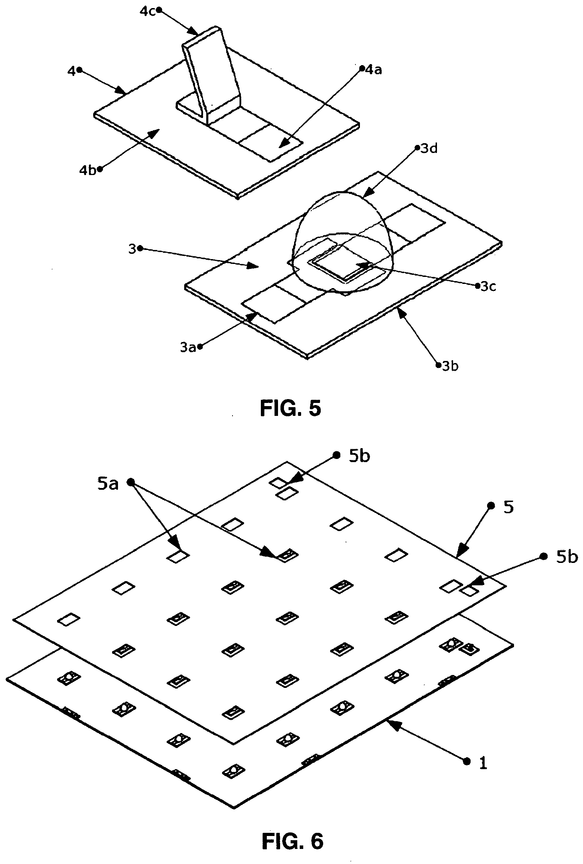

FIG. 4 shows how the CPV receivers 3 are mounted on the base plate 1. FIG. 5 shows in more detail the CPV receivers 3 on the right and the electric connection means 4 on the left. The CPV receivers 3 are made from CPV cells 3c mounted on a suitable thermally conductive substrate 3b. Insulated, for example insulated metal substrates, direct bonded copper, screen printed alumina or similar, or non-insulated substrates, for example a copper lead frame or similar, may be chosen. The cell is usually soldered to the substrate using vapour phase or vacuum reflow ovens. The substrate comprises an electric circuit, to which the cell and optionally the bypass diode are electrically connected (not shown). The receiver assembly must include some interconnection means. Secondary optics 3d or transparent potting cover the cell. Through the receiver interconnection pad 3a, electric connection may be provided to other receivers 3 or to electric connection means 4, for example end connection plates. The end connection plates 4 comprise an insulated substrate 4b, and end connector 4c and interconnection pads 4a. The insulated substrate 4b, such as PCB, i.e. a printed circuit board, or insulated metal substrate IMS, insulates electrically the end connection plates 4 from the base plate 1. While the end connector 4c is used to interconnect electrically modules (receiver panels) between them, the interconnection pad 4a is used to interconnect electrically the end connection plates 4 with a receiver 3.

Providing electric connection means 4 for interconnecting electrically modules has the advantage that this interconnection is removed from the last CPV receivers in the interconnection string 6, since the solar radiation impinging on the CPV receivers and the resulting high temperatures therefrom in the immediate surroundings of the CPV receivers may destroy or at least damage an electric interconnection of modules, which is directly connected to the CPV receivers. As may be derived from FIG. 4, the electric connection means 4 are located near the edge of the panel, facilitating subsequent electric interconnection of modules. Moreover, since the end connectors 4c are configured to protrude from the finished CPV receiver panel, electric interconnection of modules is even more simplified, since said electric interconnection can be carried out easily once the laminated CPV receiver panels have been mounted on the field.

CPV receivers 3 are mounted on top of base plate 1 using a thermally conductive adhesive, e.g. double side adhesive tape or heat conductive epoxy, or any suitable mechanical fastening method like rivets or screws, in combination with an appropriate thermal interface material like graphite pads or thermal grease. Hence, good thermal contact can be provided. A thermal interface material must also be electrically insulating if non-insulated substrates 3b are used for the CPV receivers 3. Also, a pair of end connection plates 4 is mounted on base plate 1 in a similar way as receivers 3.

A tight tolerance positioning method is required for assembling the receivers 3. A preferred method uses a 3 axis robot, which picks up receivers 3 from a tray, applies double side adhesive tape to the receiver's back, moves receiver to its X and Y positions, and presses the receiver to its position. The same procedure is followed to position the electric connection means 4.

FIG.6 shows the assembly of a first insulation layer 5. A first insulation layer 5 is made from a foil of an electrically insulating material, e.g. ethylene-vinyl-acetate, poly(ethylene-terephthalate), high-density polyethylene, poly(vinylchloride), polycarbonate, poly(methyl methacrylic acid), poly(vinylfluoride), poly(vinylidenefluoride), or similar from which rectangular windows 5a and 5b are cut-out by methods like laser cutting or stamping, in such a way that windows 5a correspond to the shape and position of receivers 3 and windows 5b correspond to the end connection plates 4. The first insulation layer 5 may be trimmed in one preferred aspect of this invention to an area smaller to that of the base plate 1, in order to allow for space to attach the mounting brackets 2. In such a case, it is preferred that the first insulation layer has for example dimensions in the range of 750 mm of length and 600 mm of width. The first insulation layer 5 is laid on top of base plate 1, in such a way that receivers 3 and end connection plates 4 fit within respective windows 5a and 5b. Thus, insulation layer 5 covers the surface of the base plate, but not the receivers 3 or the end connection plates 4.

According to a first lamination method (A) of the invention, the first insulation layer 5 may be attached to base plate 1 using adhesive film or liquid adhesive, which can be sprayed or dispensed on top of base plate 1. Additionally, it may be advisable to dispense a thin line of fluid insulating material, like silicone or polyurethane, surrounding receivers 3 and end connection plates 4, in order to fill in any possible gap left between receivers 3 and end connection plates 4 and insulation layer 5.

According to a second lamination method (B) of the invention, the first insulation layer 5 may alternatively be simply laid on top of the base plate 1 at this stage.

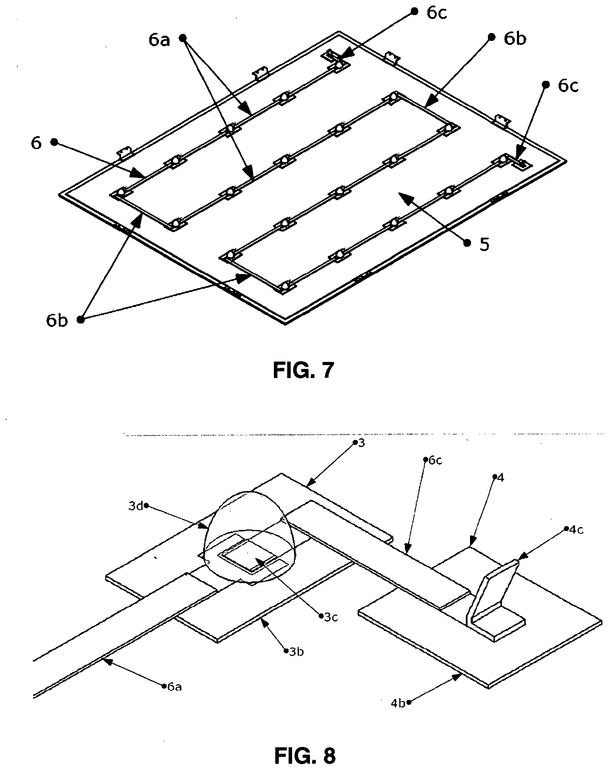

FIG. 7 shows the assembly of an electric interconnection string 6. The electric interconnection string 6 is made from electric interconnection strips 6a and 6b and 6c, or simply interconnectors 6a, 6b, 6c. The interconnectors 6a, 6b and 6c are preferably made from copper ribbon plated with a tin-silver alloy or any other suitable protection and soldering material, cut to the required length. Other metals, like nickel may be used instead of copper. The interconnectors 6a serially interconnect the receivers, which form a row in a longitudinal direction. Each row is then interconnected in a transversal direction by interconnectors 6b allowing to serially connecting all receivers 3 of the CPV receiver panel. In the example of FIG. 7, the receivers 3 may be serially interconnected starting in the top right position and following the string until the bottom right position. It will be clear to the skilled person that the electric interconnection string 6 may also run in any other alternative way provided all receivers 3 are serially interconnected. Finally, the interconnectors 6c serially interconnect in a transversal direction each of the two end receivers with one respective end connection plate 4.

In an alternative aspect, there may be more than one electric interconnection string 6. In such a case, for example, there may be a first interconnection string interconnecting serially a first portion of CPV receivers, whereas a second interconnection string interconnects serially a second portion of CPV receivers, wherein first and second interconnection string provide for an parallel electric connection.

FIG. 8 shows the serial interconnection of receiver 3 and end connection plates 4 by the electric interconnection string 6 in more detail. CPV receivers 3 are serially connected using the longitudinal and transversal oriented interconnectors 6a and 6b (the latter are not shown). These are soldered, welded or glued using conductive epoxy to the receiver interconnection pads 3a. Also, the first and the last receiver in the string 6 are connected to the end connection plates 4 by means of transversal oriented interconnectors 6c connected to the interconnection pads 4a. In FIG. 8, these pads 3a and 4a are not shown, since they are covered by the interconnectors 6a and 6c.

A preferred connection method is resistance soldering: First, interconnection pads 3a and 4a must be covered with solder paste during receiver 3 and end connection plates 4 manufacturing. A preferred manufacturing method may comprise a robot that picks an interconnector 6, for example an interconnector 6a or 6b, and places it between two receivers 3, in such a way that the tips of interconnectors 6a or 6b cover receiver interconnection pads 3a, and then pushing two electrodes on top of each interconnector tip end passing a high current pulse through the copper part covering the interconnection pad 3a. The high current pulse will heat up the interconnector tips very quickly, thus melting solder paste lying on top at interconnection pad 3a and soldering this to the interconnector tip itself. This soldering method is fast and precise, allowing a short cycle time, below 500 milliseconds. Interconnectors can be pre-cut to size or, alternatively, copper ribbon can be used and cut to size during the assembly process. Therefore, the interconnection string 6 lies on top of first Insulation layer 5.

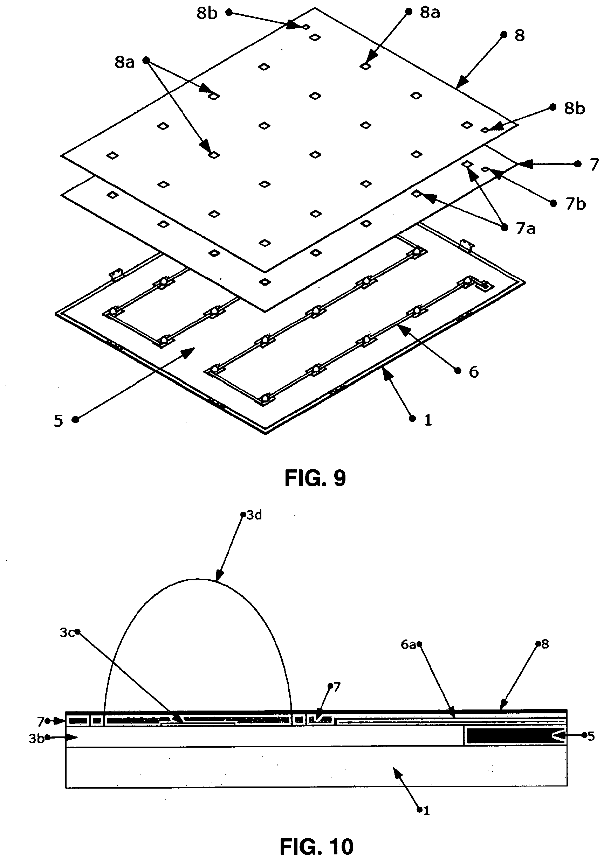

FIG. 9 shows the assembly of a second insulation layer 7 and a coversheet 8. The second insulation layer 7 is preferably made from a foil of electrically insulating material, like ethylene-vinyl-acetate, poly(ethylene-terephthalate), high-density polyethylene, poly(vinylchloride), polycarbonate, poly(methyl methacrylic acid), poly(vinylfluoride), poly(vinylidenefluoride), or similar, from which windows 7a and 7b are cut out using methods like laser cutting or stamping, in such a way that windows 7a correspond to the shape and position of the secondary optics of receivers 3, and windows 7b correspond to end connectors 4c on end connection plates 4. The second insulation layer 7 is trimmed to the same size as first insulation layer 5, and laid on top of the previous assembly, in such a way that secondary optics 3d of the receivers and the end connectors 4c on end connection plates 4 fit within respective windows 7a and 7b. Therefore, the second insulation layer 7 covers the interconnection string 6, and partially covers receivers 3, the end connection plates 4 and first insulation layer 5, but not the secondary optics 3d or the end connectors 4c. The windows 7a and 7b on second insulation layer 7 may be smaller than windows 5a and 5b on first insulation layer 5, allowing in such a case covering any electrically hot metal surfaces with insulation material. Therefore, interconnection string 6 is thus sandwiched between two layers of electrically insulating material.

According to a first lamination method (A) of the invention, the second insulation layer 7 may be attached to the previous assembly using adhesive film or liquid adhesive, which can be sprayed or dispensed on top of previous assembly. According to aspect second lamination method (B) of the invention, the second insulation layer 7 is alternatively just laid on top of the previous assembly at this stage.

The coversheet 8 of FIG. 9 may be made of aluminium or any other suitable material, either able to reflect or withstand off-focus radiation. The sheet is trimmed to the same size as insulation layers 5 and 7 and windows 8a and 8b are cut-out with the same shape and position as windows 7a and 7b on insulation layer 7.

According to a first lamination method (A) of the invention, the coversheet 8 is attached to the previous assembly using adhesive film or liquid adhesive which can be sprayed or dispensed on top of previous assembly. After allowing for the adhesives to cure (by room temperature vulcanisation or any other means), the laminated receiver panel is finished.

According to a second lamination method (B) of the invention, coversheet 8 may alternatively be simply laid on top of the previous assembly at this stage, covering the second insulation layer 7. Here, the different layers 1, 5, 7, and 8 composing the receiver panel are just assembled one over another as a layer stack at this stage as is shown in FIG. 2. Ethylene-vinyl-acetate or a similar material may be used for first insulation layer 5 and second insulation layer 7. A heat curing process under vacuum is needed to fully assemble and encapsulate the receiver panel, resulting thus in the laminated receiver panel. For ethylene-vinyl-acetate material this process takes about 20 minutes at 140 °C.

Hence, the receiver panel provides a sandwiched receiver electric interconnection system between two insulation layers, which may be dielectric, with a top off-focus radiation protection layer and a bottom structural base plate, of a material like aluminium, acting also as heat sink, yielding a completely protected laminated receiver panel, which fulfils the insulation requirements even under wet conditions.

Particularly when the heat curing process under vacuum, i.e. method (B), is used, an excellent insulation under wet conditions is obtained. The reason is that the applied vacuum eliminates all air that might be present between the individual layers, so that a very tight and closed laminated receiver panel may be obtained. Moreover, method (B) may be carried out faster and is cleaner compared to the use of adhesives.

FIG. 10 is a cross-section of the receiver panel of FIG. 1, in which said sandwiched receiver electric interconnection system is illustrated. A receiver 3 is mounted on the base plate 1. As may be derived from FIG. 10, the electric interconnection between receiver and the interconnection string 6 is completely protected between the two insulation layers 5 and 7. Over the layer 7 there is the coversheet 8 protecting the receiver panel from off-focus radiation. Moreover, the receiver protrudes with its upper part, here in particular the secondary optics 3d, from the receiver panel, so that solar radiation may reach the receiver 3.

For purposes of convenience, the manufacturing of the CPVLIS receiver panel is described here once more. The lamination method for the manufacture of the CPVLIS receiver panel comprises the steps of providing a thermally conductive base plate; mounting a plurality of CPV receivers on the base plate; providing thereon a first insulation layer configured to allow solar radiation to be focussed inside the CPV receiver solar aperture; providing an interconnection string for connecting the plurality of CPV receivers; providing thereon a second insulation layer configured to allow solar radiation to be focussed inside the CPV receiver solar aperture; providing thereon a coversheet configured to allow solar radiation to be focussed inside the CPV receiver solar aperture; and hardening the assembled layers to form a laminated receiver panel.

According to aspect preferred first lamination method (A) of the invention, the assembling of the layer stack is carried out as follows. After the CPV receivers 3 and the pair of end connection plates 4 have been mounted on the base plate 1, the first insulation layer 5 is attached to said base plate 1 using an adhesive, for example adhesive film or liquid adhesive, which can be sprayed or dispensed on top of the base plate 1. Additionally, a thin line of fluid insulating material may be dispensed surrounding receivers 3 and connection plates 4, in order to fill in any possible gap left between receivers 3 and connection plates 4 and insulation layer 5. Then, the interconnection string 6 including the interconnectors 6a, 6b, and 6c is formed on top of the first insulation layer 5 using soldering, welding or gluing. After that step, the second insulation layer 7 is attached on top of the already formed layer stack in the same way as for first insulation layer 5. Then, the coversheet 8 is attached on top of the second insulation layer 7 in the same way as for first insulation layer 5. Finally, the receiver panel is finished by carrying out a room temperature vulcanisation to cure the adhesives.

According to aspect preferred second lamination method (B) of the invention, the assembling of the layer stack may be carried out by laying the first insulation layer 5 on top of the base plate 1 after the CPV receivers 3 and the pair of end connection plates 4 have been mounted on said base plate 1. Then the interconnection string 6 is formed on top of first insulation layer 5 as described above. After that step, the second insulation layer 7 is laid on top of the already formed layer stack, and then the coversheet 8 is laid on top of second insulation layer 7, thereby covering said layer 7. At this stage, the different layers composing the receiver panel are just piled one over another. In this aspect of the invention, the first and second insulation layers 5, 7 are made from ethylene-vinyl-acetate or a similar material to fully assemble and encapsulate the receiver panel in a heat curing process under vacuum. In case that ethylene-vinyl-acetate has been used for first and second insulation layers 5 and 7, the heat curing process under vacuum will take about 20 minutes at 140 °C.

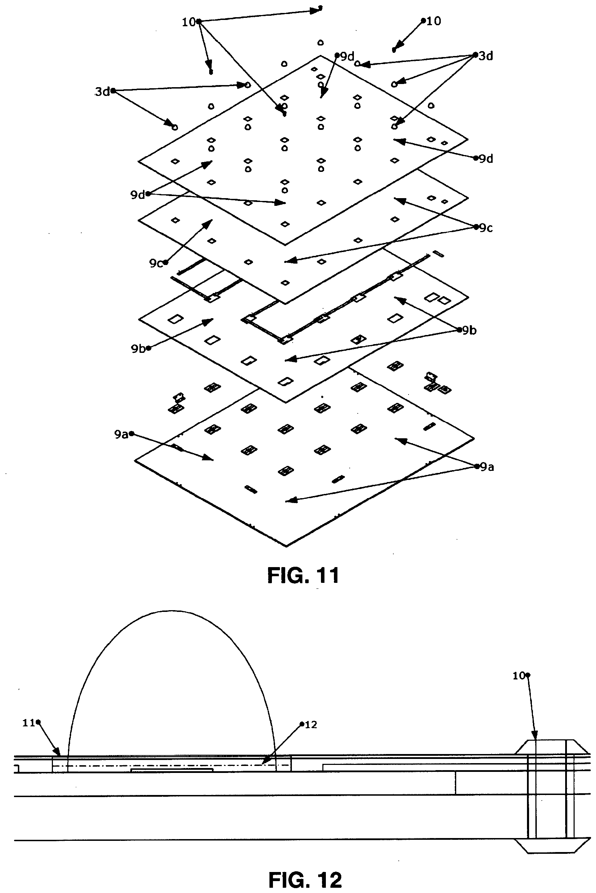

FIGS. 11 and 12 shows an assembly method involving a preferred third lamination method (C) of the invention, wherein CPV receivers 3 have been used, which do not have secondary optics 3d initially attached to them. Instead, these secondary optics 3d are assembled in the last step of the laminate assembly process or lamination method, prior to adhesive or heat curing. Hence, the preferred first and second lamination methods (A) and (B) previously described herein will slightly differ in that the different layers composing the laminated receiver panel incorporate additionally placement holes 9 to fix all the layers in position accurately before the curing process. In order to reach that, base plate 1, first insulation layer 5, second insulation layer 7 and coversheet 8 incorporate coincident placement holes 9a, 9b, 9c and 9d respectively.

After the steps described in relation in FIG. 9, but before adhesive or heat curing, the laminated receiver panel may be riveted through placement holes 9 using sealed blind rivets 10 as shown in FIG. 12. Using this preferred third lamination method, it is possible to obtain the different components laminated as described previously, but before adhesive or heat curing, the following receiver attachment process may be executed.

This receiver attachment process may be performed by a pick and place machine. As indicated in FIG. 12, the pick and place machine will first dispense an optical adhesive able to sustain long term concentrated irradiation, like optical silicone or any other suitable material, into recesses 11 constituted by windows 7a and 8a, filling them up to a desired height. Second, the machine will pick a secondary optics 3d and place it inside a recess 11, on top of optical adhesive layer 12. This step is repeated for all secondary optics 3d in the receiver panel. Finally, the lamination process is finished by room temperature vulcanisation or vacuum heat adhesive curing.

The laminated receiver panel obtained according to the invention may be integrated in a concentration photovoltaic module or a concentration photovoltaic system, which is to be mounted in the field.

The present invention may also comprise an installation for manufacturing the laminated receiver panels of the invention. Said installation may comprise means for placing a plurality of CPV receivers 3 on the thermally conductive base plate 1; means for providing the first insulation layer 5 on the base plate 1; means for providing the electric interconnection string 6 on the first insulation layer 5; means for providing the second insulation layer 7 on the first insulation layer 5; means for providing the coversheet 8 on the second insulation layer 7; and means for connecting the plurality of CPV receivers 3 using the electric interconnection string 6.

It is to be understood by the skilled person in the art that the various embodiments, realizations, and aspects of the invention have been so drafted with the aim of disclosing the invention in a concise manner. This does not mean that the intention is of limiting the scope of the disclosure to the precise combination of embodiments, realizations, and aspects as drafted. On the other hand, the intention is that the different features of the inventive concepts described may be readily understood to be combinable as would be derived from a clear and objective reading of the disclosure by one of ordinary skill in the art.

Those skilled in the art should appreciate that the foregoing discussion of one or more embodiments does not limit the present invention, nor do the accompanying figures. Rather, the present invention is limited only by the following claims.

## Claims

1. A laminated receiver panel for a concentration photovoltaics (CPV) system, the receiver panel comprising:
a thermally conductive base plate (1) with a plurality of CPV receivers (3) mounted on top of the base plate in good thermal contact;
a first insulation layer (5);
a second insulation layer (7);
a coversheet (8); and
an electric interconnection string (6) sandwiched between the first and the second insulation layers (5, 7) for connecting the CPV receivers (3);
wherein the first insulation layer (5) is configured to allow said good thermal contact between CPV receivers (3) and the base plate (1) by means of a plurality of windows (5a) corresponding to the position and shape of the plurality of CPV receivers (3), and
the second insulation layer (7) and the coversheet (8) are configured to allow solar radiation to be focussed within CPV receiver solar aperture secondary optics (3d), by means of a plurality of windows (7a, 8a) corresponding to the position and shape of the secondary optics (3d) of the receivers (3) such that the secondary optics (3d) protrude from the coversheet (8).

2. The receiver panel of claim 1, wherein the receiver panel further comprises at least two electric connection means (4) mounted on top of the base plate (1) comprising an insulated substrate (4b) and an end connector (4c), the end connector (4c) being configured to provide for external electric interconnection with other modules.

3. The receiver panel of claim 2, wherein the thermally conductive base plate (1) comprises mounting reference holes (1a), and optional mounting brackets (2) fastened to the base plate (1) through said mounting reference holes (1a); wherein the back surface of the base plate (1) has been surface-treated by means of anodising or painting; and the thermally conductive base plate (1) is a material selected from aluminium or aluminium alloys.

4. The receiver panel of claim 2, wherein each CPV receiver (3) comprises a CPV cell (3c) mounted on a thermally conductive substrate (3b), and is covered by secondary optics or transparent potting (3d); and/or
wherein the coversheet (8) is made from a material that reflects or withstands off-focus radiation, preferably the material is aluminium; and/or
further comprising placement holes (9a, 9b, 9c, 9d) in each of the base plate (1), the first insulation layer (5), the second insulation layer (7) and the coversheet (8), wherein said placement holes of each layer coincide with the placement holes of the other layers.

5. The receiver panel of claim 2, wherein the first insulation layer (5) and/or the second insulation layer (7) are made of an electrically insulating material selected from the group comprising ethylene-vinyl-acetate, poly(ethylene-terephthalate), high-density polyethylene, poly(vinylchloride), polycarbonate, poly(methyl methacrylic acid), poly(vinylfluoride), or poly(vinylidenefluoride); preferably wherein the first and the second insulation layers (5, 7) are trimmed to a size smaller than the size of the base plate (1); and
preferably wherein the coversheet (8) is trimmed to the same size as first and second insulation layers (5, 7).

6. The receiver panel of claim 2, wherein the first insulation layer (5), the second insulation layer (7), and the coversheet (8) additionally comprise a plurality of windows (5b, 7b, 8b) corresponding to the at least two electric connection means (4), the windows(5b, 7b, 8b) allowing the at least two electric connection means (4) to protrude from the coversheet (8);
preferably wherein the windows (7a, 7b) of the second insulation layer (7) are smaller than the windows (5a, 5b) of the first insulation layer (5), allowing the second insulation layer (7) to cover partially the CPV receivers (3), partially the at least two electric connection means (4), and first insulation layer (5): and preferably wherein the windows (8a, 8b) of the coversheet (8) have the same size as the windows (7a, 7b) of the second insulation layer (7).

7. The receiver panel of claim 2, wherein the interconnection string (6) comprises a plurality of longitudinal and transversal interconnectors (6a, 6b, 6c) connecting the plurality of CPV receivers (3), and connecting a first CPV receiver of the interconnected string of CPV receivers (3) with the interconnection pad (4a) of a first electric connection means, and connecting a last CPV receiver of the interconnected string of CPV receivers (3) with the interconnection pad (4a) of a second electric connection means, preferably wherein the longitudinal and transversal interconnectors (6a, 6b, 6c) are made from copper ribbon plated with a tin-silver alloy and soldering material.

8. A method for manufacturing a laminated receiver panel, comprising the steps of:
providing a thermally conductive base plate (1);
mounting a plurality of CPV receivers (3) on the base plate (1);
providing thereon a first insulation layer (5);
providing an interconnection string (6) for connecting the plurality of CPV receivers (3);
providing thereon a second insulation layer (7);
providing thereon a coversheet (8); and
curing the assembled layers to form a laminated receiver panel;
wherein the first insulation layer (5) is configured to allow good thermal contact between CPV receivers (3) and base plate (1) by means of a plurality of windows (5a) corresponding to the position and shape of the plurality of CPV receivers (3), and
wherein the second insulation layer (7) and the coversheet (8) are configured to allow solar radiation to be focussed within CPV receiver solar aperture secondary optics (3d), by means of a plurality of windows (7a, 8a) corresponding to the position and shape of the secondary optics (3d) such that the secondary optics (3d) protrude from the coversheet (8).

9. The method of claim 8, comprising further the step of:
providing at least two electric connection means (4) on the base plate (1), the electric connection means (4) being configured to provide for electric interconnection.

10. The method of claim 9, further comprising either the steps of:
forming the interconnection string (6) on top of the first insulation layer (5);
laying the second insulation layer (7) on top of first insulation layer (5), totally covering the interconnection string (6), while partially covering the receivers (3), the at least two electric connection means (4) and first insulation layer (5); and
wherein curing the assembled layer stack is carried out by heat curing the assembled layer stack under vacuum; or
the steps of:
attaching the first insulation layer (5) to the base plate (1) using a curable adhesive;
forming the interconnection string (6) on top of the first insulation layer (5);
attaching the second insulation layer (7) to the first insulation layer (5) using a curable adhesive;
attaching the coversheet (8) to the second insulation layer (7) using a curable adhesive; and
wherein curing the assembled layers is carried out by adhesive curing.

11. The method of claim 10, wherein, after attaching the first insulation layer (5), an insulating material is provided in the surroundings of the CPV receivers (3) and the end connection plates (4).

12. The method of claim 9, wherein the interconnection string (6) is formed on top of the first insulation layer (5) by soldering, welding or gluing the interconnectors (6a, 6b, 6c) to the CPV receivers (3) and the at least two electric connection means (4), preferably wherein resistance soldering is used for forming the interconnection string (6).

13. The method of claim 9, wherein assembling the layers comprises, before carrying out the step of curing,
fastening the assembled layers through coincident placement holes (9a, 9b, 9c, 9d);
filling the recesses (11) in the windows (7a, 8a) from which the CPV receivers (3) protrude with an optical adhesive, to form an optical adhesive layer (12);
placing secondary optics (3d) in said recesses (11) on top of said optical adhesive layer (12).

14. A concentration photovoltaic system comprising a laminated receiver panel according to claim 1.

15. An installation for manufacturing laminated receiver panels according to claim 1 comprising:
means for placing a plurality of CPV receivers (3) on a thermally conductive base plate (1);
means for providing a first insulation layer (5) on the base plate (1);
means for providing an electric interconnection string (6) on the first insulation layer (5);
means for providing a second insulation layer (7) on the first insulation layer (5);
means for providing a coversheet (8) on the second insulation layer (7); and
means for connecting the plurality of CPV receivers (3) using the electric interconnection string (6);
wherein the first insulation layer (5) is configured to allow good thermal contact between CPV receivers (3) and base plate (1) by means of a plurality of windows (5a) corresponding to the position and shape of the plurality of CPV receivers (3), and
the second insulation layer (7) and the coversheet (8) are configured to allow solar radiation to be focussed within CPV receiver solar aperture secondary optics (3d), by means of a plurality of windows (7a, 8a) corresponding to the position and shape of the secondary optics (3d) such that the secondary optics (3d) protrude from the coversheet (8).

## Patentansprüche

1. Ein laminiertes Empfänger-Panel für ein Konzentrator-Photovoltaik-System (CPV), wobei das Empfänger-Panel umfasst:
eine thermisch leitfähige Grundplatte (1) mit einer Mehrzahl an CPV-Empfängern (3), die auf der Oberseite der Grundplatte mit gutem thermischen Kontakt befestigt sind;
eine erste Isolationsschicht (5);
eine zweite Isolationsschicht (7);
eine Abdeckung (8) und
ein elektrisches Verbindungskabel (6) zwischen der ersten und der zweiten Isolationsschicht (5, 7) zum Anschluss der CPV-Empfänger (3);
wobei die erste Isolationsschicht (5) so konfiguriert ist, dass sie den besagten guten thermischen
Kontakt zwischen CPV-Empfängern (3) und der Grundplatte (1) durch die Mehrzahl der Fenster (5a) erlaubt, die der Position und Form der Mehrzahl der CPV-Empfänger (3) entsprechen, und
wobei die zweite Isolationsschicht (7) und die Abdeckung (8) so konfiguriert sind,
dass die
Sonnenstrahlen innerhalb der sekundären Optik (3d) der CPV-Solar-Empfänger-Blende
durch die Mehrzahl der Fenster (7a, 8a),
die der Position und Form der sekundären Optik (3d) des Empfängers (3) entsprechen, fokussiert werden, sodass die sekundäre Optik (3d) aus der Abdeckung (8) hervorsteht.

2. Das Empfänger-Panel nach Anspruch 1, wobei das Empfänger-Panel zusätzlich mindestens zwei elektrische Anschlussmittel (4) umfasst, die auf der Oberseite der Grundplatte (1) befestigt sind, welche einen isolierenden Träger (4b) und einen Endanschluss (4c) umfassen,
wobei der Endanschluss (4c) so ausgelegt ist, dass er den externen elektrischen Anschluss
anderer Module gestattet.

3. Das Empfänger-Panel nach Anspruch 2, wobei die thermisch leitfähige Grundplatte (1)
über Befestigungsreferenzbohrungen (1 a) und optionale Befestigungshalterungen (2) verfügt,
die an der Grundplatte (1) durch besagte Befestigungsreferenzbohrungen (1a) befestigt sind;
wobei die Rückseite der Grundplatte (1) mittels Eloxierung oder Lackierung oberflächenbehandelt wurde; und die thermisch leitfähige Grundplatte (1) ein Material ausgewählt aus Aluminium oder Aluminiumlegierungen ist.

4. Das Empfänger-Panel nach Anspruch 2, wobei jeder CPV-Empfänger (3) eine CPV-Zelle (3c) umfasst, die auf einem thermisch leitfähigen Träger (3b) befestigt ist, und durch eine sekundäre Optik oder einen transparenten Verguss (3d) abgedeckt ist; und/oder
wobei die Abdeckung (8) aus einem Material gefertigt ist, das defokussierte Strahlen reflektiert oder diesen widersteht, wobei das Material bevorzugterweise Aluminium ist; und/oder die ferner über Platzierungsbohrungen (9a, 9b, 9c, 9d) in der Grundplatte (1), der ersten Isolationsschicht (5), der zweiten Isolationsschicht (7) und der Abdeckung (8) verfügt, bei der besagte Platzierungsbohrungen jeder Schicht mit den Platzierungsbohrungen der anderen Schichten übereinstimmen.

5. Das Empfänger-Panel nach Anspruch 2, wobei die erste Isolationsschicht (5) und/oder die zweite Isolationsschicht (7) aus elektrisch isolierendem Material gefertigt sind, welches ausgewählt ist aus der Gruppe umfassend EthylenVinylacetat, Poly(ethylenterephthalat), hochdichtes Polyethylen, Poly(vinylchlorid), Polycarbonat, Poly(methylmethacrylsäure), Poly(vinylfluorid) und Poly(vinylidenfluorid) bestehen;
wobei die erste und zweite Isolationsschicht (5, 7) bevorzugt auf eine kleinere Größe als die der Grundplatte (1) angepasst ist; und wobei die Abdeckung (8) bevorzugt auf dieselbe Größe wie die erste und zweite Isolationsschicht (5, 7) angepasst ist.

6. Das Empfänger-Panel nach Anspruch 2, wobei die erste Isolationsschicht (5), die zweite Isolationsschicht (7) und die Abdeckung (8) zusätzlich eine Mehrzahl von Fenstern (5b, 7b, 8b) umfassen, die den mindestens zwei elektrischen Anschlussmitteln (4) entsprechen, und die den mindestens zwei elektrischen Anschlussmitteln (4) ein Hervorstehen aus der Abdeckung (8) ermöglichen; wobei die Fenster (7a, 7b) der zweiten Isolationsschicht (7) bevorzugt kleiner als die Fenster (5a, 5b) der ersten Isolationsschicht (5) sind, und es der zweiten Isolationsschicht (7) ermöglichen, die CPV-Empfänger (3), die mindestens zwei elektrischen Anschlussmittel (4) und die erste Isolationsschicht (5) teilweise zu bedecken, und
wobei die Fenster (8a, 8b) der Abdeckung (8) bevorzugt dieselbe Größe wie die Fenster (7a, 7b) der zweiten Isolationsschicht (7) haben.

7. Das Empfänger-Panel nach Anspruch 2, wobei das Verbindungskabel (6) aus einer
Mehrzahl an Längs- und Querverbindern (6a, 6b, 6c) besteht, die die Mehrzahl an CPV-Empfängern (3) verbinden, und die einen ersten CPV-Empfänger des Verbindungskabels der CPV-Empfänger (3) mit dem Verbindungspad (4a) eines ersten elektrischen Anschlussmittels verbinden, und einen letzten CPV-Empfänger des Verbindungskabels des CPV-Empfängers (3) mit dem Verbindungspad (4a) eines zweiten elektrischen Anschlussmittels verbinden, wobei die Längs- und Querverbinder (6a, 6b, 6c) bevorzugt aus Kupferband gefertigt und mit einer Zinn-Silber-Legierung und Lötmaterial plattiert sind.

8. Verfahren zur Herstellung eines laminierten Empfänger-Panels, wobei das Verfahren die Schritte umfasst:
Bereitstellen einer thermisch leitfähigen Grundplatte (1);
Befestigen einer Mehrzahl an CPV-Empfängern (3) auf der Grundplatte (1);
Bereitstellen einer ersten Isolationsschicht (5) darauf;
Bereitstellen eines Verbindungskabels (6) zum Anschluss der Mehrzahl der CPV-Empfänger (3);
Bereitstellen einer zweiten Isolationsschicht (7) darauf;
Bereitstellung einer Abdeckung (8) darauf; und
Härten der zusammengesetzten Schichten, um ein laminiertes Empfänger-Panel zu bilden;
wobei die erste Isolationsschicht (5) dazu konfiguriert ist, einen guten thermischen Kontakt zwischen CPV-Empfängern (3) und Grundplatte (1) durch eine Mehrzahl an Fenstern (5a) zu ermöglichen, die der Position und Form der Pluralität der CPV-Empfänger (3) entsprechen;
und
wobei die zweite Isolationsschicht (7) und die Abdeckung (8) so konfiguriert sind, dass
Sonnenstrahlen innerhalb der sekundären Optik (3d) der CPV-Solar-Empfänger-Blende durch die Mehrzahl der Fenster (7a, 8a), die der Position und Form der sekundären Optik (3d) entsprechen, fokussiert werden können, sodass die sekundäre Optik (3d) aus der Abdeckung (8) hervorsteht.

9. Verfahren nach Anspruch 8, weiter umfassend den Schritt des:
Bereitstellens von mindestens zwei elektrischen Anschlussmitteln (4) auf der Grundplatte (1), wobei die elektrischen Anschlussmittel (4) dazu konfiguriert sind, einen elektrischen Anschluss bereitzustellen.

10. Verfahren nach Anspruch 9, weiter umfassend entweder die Schritte des:
Formens des Verbindungskabels (6) auf der Oberseite der ersten Isolationsschicht (5);
Verlegen der zweiten Isolationsschicht (7) auf der Oberseite der ersten Isolationsschicht (5), wodurch das Verbindungskabel (6) vollständig abgedeckt wird und die Empfänger (3),
die mindestens zwei elektrischen Anschlussmittel (4) und die erste Isolationsschicht (5) teilweise abgedeckt werden; und wobei ein Härten der zusammengesetzten Schichten mittels Wärmehärtung der zusammengesetzten Schicht im Vakuum durchgeführt wird; oder
die Schritte:
Befestigen der ersten Isolationsschicht (5) auf der Grundplatte (1) mittels aushärtbaren
Klebstoffes;
Formen des Verbindungskabels (6) auf der Oberseite der ersten Isolationsschicht (5);
Befestigen der zweiten Isolationsschicht (7) auf der ersten Isolationsschicht (5) mittels eines
aushärtbaren Klebstoffes;
Befestigen der Abdeckung (8) auf der zweiten Isolationsschicht (7) mittels eines aushärtbaren
Klebstoffes; und
wobei das Härten der zusammengesetzten Schichten mittels Klebstoff-Aushärtung durchgeführt wird.

11. Verfahren nach Anspruch 10, wobei nach dem Befestigen der ersten Isolationsschicht (5) ein Isolationsmaterial in der Umgebung der CPV-Empfänger (3) und den Endanschlussplatten (4) bereitgestellt wird.

12. Verfahren nach Anspruch 9, wobei das Verbindungskabel (6) auf der Oberseite der ersten Isolationsschicht (5) durch Löten, Schweißen oder Kleben der Anschlüsse (6a, 6b, 6c) an die CPV-Empfänger (3) und die mindestens zwei elektrischen Anschlussmittel (4) ausgebildet wird, wobei vorzugsweise ein Widerstandslötverfahren für das Formen des Verbindungskabels (6) verwendet wird.

13. Verfahren nach Anspruch 9, wobei das Zusammensetzen der Schichten, bevor der Schritt zum Härten durchgeführt wird, [umfasst]:
Befestigen der zusammengefügten Schichten mittels übereinstimmender Platzierungsbohrungen (9a, 9b, 9c, 9d);
Auffüllen der Aussparungen (11) in den Fenstern (7a, 8a), aus denen die CPV-Empfänger (3) hervorstehen, mit optischem Klebstoff, um eine optische Klebeschicht (12) zu bilden;
Platzieren einer sekundären Optik (3d) in besagten Aussparungen (11) auf der Oberseite besagter optischer Klebeschicht (12).

14. Konzentrator-Photovoltaik-System, das ein laminiertes Empfänger-Panel gemäß Anspruch 1 umfasst.

15. Anlage zur Herstellung laminierter Empfänger-Panele gemäß Anspruch 1, umfassend:
Mittel zur Platzierung einer Mehrzahl an CPV-Empfängern (3) auf einer thermisch leitfähigen
Grundplatte (1);
Mittel zur Bereitstellung einer ersten Isolationsschicht (5) auf der Grundplatte (1);
Mittel zur Bereitstellung eines elektrischen Verbindungskabels (6) auf der ersten Isolationsschicht (5);
Mittel zur Bereitstellung einer zweiten Isolationsschicht (7) auf der ersten Isolationsschicht (5);
Mittel zur Bereitstellung einer Abdeckung (8) auf der zweiten Isolationsschicht (7); und
Mittel zum Anschluss der Mehrzahl der CPV-Empfänger (3) mittels eines elektrischen
Verbindungskabels (6);
wobei die erste Isolationsschicht (5) so konfiguriert ist, dass sie einen guten thermischen Kontakt zwischen den CPV-Empfängern (3) und der Grundplatte (1) mittels einer Mehrzahl an Fenstern (5) ermöglicht, die der Position und Form der Mehrzahl der CPV-Empfänger (3) entsprechen; und
die zweite Isolationsschicht (7) und die Abdeckung (8) so konfiguriert sind, dass Sonnenstrahlen innerhalb der sekundären Optik (3d) der CPV-Solar-Empfänger-Blende durch die Mehrzahl der Fenster (7a, 8a), die der Position und Form der sekundären Optik (3d) entsprechen, fokussiert werden, sodass die sekundäre Optik (3d) aus der Abdeckung (8) hervorsteht.

## Revendications

1. Panneau récepteur stratifié destiné à un système photovoltaïque à concentration (CPV), le panneau de récepteurs comprenant :
une plaque de base thermiquement conductrice (1) avec une pluralité de récepteurs CPV (3) montés sur la plaque de base en bon contact thermique ;
une première couche d'isolation (5) ;
une seconde couche d'isolation (7) ;
une feuille de protection (8) ; et
une chaine d'interconnexion électrique (6) prise en sandwich entre les première et seconde couches d'isolation (5, 7) pour connecter les récepteurs CPV (3) ;
dans lequel la première couche d'isolation (5) est configurée pour permettre ledit bon contact thermique entre les récepteurs CPV (3) et la plaque de base (1) à l'aide d'une pluralité de fenêtres (5a) correspondant à la position et à la forme de la pluralité de récepteurs CPV (3), et
la seconde couche d'isolation (7) et la feuille de protection (8) sont configurées pour permettre au rayonnement solaire d'être concentré dans l'optique secondaire à ouverture solaire de récepteur CPV (3d), à l'aide d'une pluralité de fenêtres (7a, 8a) correspondant à la position et à la forme de l'optique secondaire (3d) des récepteurs (3) de telle sorte que l'optique secondaire (3d) fait saillie depuis la feuille de protection (8).

2. Panneau récepteur selon la revendication 1, dans lequel le panneau de récepteurs comprend en outre au moins deux moyens de connexion électrique (4) montés sur la plaque de base (1) comprenant un substrat isolé (4b) et un connecteur d'extrémité (4c), le connecteur d'extrémité (4c) étant configuré pour fournir une connexion électrique externe avec d'autres modules.

3. Panneau récepteur selon la revendication 2, dans lequel la plaque de base thermiquement conductrice (1) comprend des trous de référence de montage (1a), et des supports de montage optionnels (2) fixés à la plaque de base (1) par l'intermédiaire desdits trous de référence de montage (1 a) ; dans lequel la surface arrière de la plaque de base (1) a été traitée en surface à l'aide d'une anodisation ou d'une peinture ; et la plaque de base thermiquement conductrice (1) est un matériau sélectionné parmi l'aluminium ou les alliages d'aluminium.

4. Panneau récepteur selon la revendication 2, dans lequel chaque récepteur CPV (3) comprend une cellule CPV (3c) montée sur un substrat thermiquement conducteur (3b), et est recouvert par de l'optique secondaire ou matériau d'imprégnation transparent (3d) ; et/ou
dans lequel la feuille de protection (8) est fabriquée à partir d'un matériau qui réfléchit ou résiste au rayonnement défocalisé, le matériau étant de préférence de l'aluminium ; et/ou
comprenant en outre des trous de mise en place (9a, 9b, 9c, 9d) dans chacune de la plaque de base (1), de la première couche d'isolation (5), de la seconde couche d'isolation (7) et de la feuille de protection (8), dans lequel lesdits trous de mise en place de chaque couche coïncident avec les trous de mise en place des autres couches.

5. Panneau récepteur selon la revendication 2, dans lequel la première couche d'isolation (5) et/ou la seconde couche d'isolation (7) sont faites d'un matériau électriquement isolant sélectionné dans le groupe comprenant l'éthylène-vinyle-acétate, le poly(éthylène-téréphtalate), le polyéthylène haute-densité, le poly(chlorure de vinyle), le polycarbonate, le poly(méthyle méthacrylique acide), le poly(fluorure de vinyle) ou le poly(fluorure de vinylidène) ;
de préférence dans lequel les première et seconde couches d'isolation (5, 7) sont découpées à une taille inférieure à la taille de la plaque de base (1) ; et
de préférence dans lequel la feuille de protection (8) est découpée à la même taille que les première et seconde couches d'isolation (5, 7).

6. Panneau récepteur selon la revendication 2, dans lequel la première couche d'isolation (5), la seconde couche d'isolation (7) et la feuille de protection (8) comprennent en plus une pluralité de fenêtres (5b, 7b, 8b) correspondant aux au moins deux moyens de connexion électrique (4), les fenêtres (5b, 7b, 8b) permettant aux au moins deux moyens de connexion électrique (4) de faire saillie depuis la feuille de protection (8) ;
de préférence dans lequel les fenêtres (7a, 7b) de la seconde couche d'isolation (7) sont plus petites que les fenêtres (5a, 5b) de la première couche d'isolation (5), permettant à la seconde couche d'isolation (7) de recouvrir partiellement les récepteurs CPV (3), partiellement les au moins deux moyens de connexion électrique (4), et la première couche d'isolation (5) ; et
de préférence dans lequel les fenêtres (8a, 8b) de la feuille de protection (8) ont la même taille que les fenêtres (7a, 7b) de la seconde couche d'isolation (7).

7. Panneau récepteur selon la revendication 2, dans lequel la chaine d'interconnexion (6) comprend une pluralité d'interconnecteurs longitudinaux et transversaux (6a, 6b, 6c) connectant la pluralité de récepteurs CPV (3), et connectant un premier récepteur CPV de la chaine interconnectée de récepteurs CPV (3) à la plaquette d'interconnexion (4a) d'un premier moyen de connexion électrique, et connectant un dernier récepteur CPV de la chaine interconnectée de récepteurs CPV (3) à la plaquette d'interconnexion (4a) d'un second moyen de connexion électrique, de préférence dans lequel les interconnecteurs longitudinaux et transversaux (6a, 6b, 6c) sont faits d'un ruban de cuivre plaqué d'un alliage d'étain-argent et d'un matériau de soudage.

8. Procédé pour fabriquer un panneau récepteur stratifié de, comprenant les étapes consistant à :
former une plaque de base thermiquement conductrice (1) ;
monter une pluralité de récepteurs CPV (3) sur la plaque de base (1) ;
former sur celle-ci une première couche d'isolation (5) ;
former une chaine d'interconnexion électrique (6) pour connecter la pluralité de récepteurs CPV (3) ;
former sur celle-ci une seconde couche d'isolation (7) ;
former sur celle-ci une feuille de protection (8) ; et
faire durcir les couches assemblées pour former un panneau de récepteurs stratifié ;
dans lequel la première couche d'isolation (5) est configurée pour permettre un bon contact thermique entre les récepteurs CPV (3) et la plaque de base (1) à l'aide d'une pluralité de fenêtres (5a) correspondant à la position et à la forme de la pluralité de récepteurs CPV (3), et
dans lequel la seconde couche d'isolation (7) et la feuille de protection (8) sont configurées pour permettre au rayonnement solaire d'être concentré dans l'optique secondaire à ouverture solaire de récepteur CPV (3d), à l'aide d'une pluralité de fenêtres (7a, 8a) correspondant à la position et à la forme de l'optique secondaire (3d) de telle sorte que l'optique secondaire (3d) fait saillie depuis la feuille de protection (8).

9. Procédé selon la revendication 8, comprenant en outre l'étape consistant à :
former au moins deux moyens de connexion électrique (4) sur la plaque de base (1), les moyens de connexion électrique (4) étant configurés pour fournir une interconnexion électrique.

10. Procédé selon la revendication 9, comprenant en outre les étapes consistant à :
former la chaine d'interconnexion (6) sur la première couche d'isolation (5) ;
coucher la seconde couche d'isolation (7) sur la première couche d'isolation (5),
recouvrant totalement la chaine d'interconnexion (6), tout en recouvrant partiellement les récepteurs (3), les au moins deux moyens de connexion électrique (4) et la première couche d'isolation (5) ; et
dans lequel le durcissement de la pile de couches assemblées est réalisé par le thermodurcissement de la pile de couches assemblées sous vide ; ou
les étapes consistant à :
attacher la première couche d'isolation (5) à la plaque de base (1) à l'aide d'un adhésif durcissable ;
former la chaine d'interconnexion (6) sur la première couche d'isolation (5) ;
attacher la seconde couche d'isolation (7) à la première couche d'isolation (5) à l'aide d'un adhésif durcissable ;
attacher la feuille de protection (8) à la seconde couche d'isolation (7) à l'aide d'un adhésif durcissable ; et
dans lequel le durcissement des couches assemblées est réalisé par un durcissement d'adhésif.

11. Procédé selon la revendication 10, dans lequel, après avoir attaché la première couche d'isolation (5), un matériau d'isolation est fourni dans les environs des récepteurs CPV (3) et des plaques de connexion d'extrémité (4).

12. Procédé selon la revendication 9, dans lequel la chaine d'interconnexion (6) est formée sur la première couche d'isolation (5) en brasant, soudant ou collant les interconnecteurs (6a, 6b, 6c) aux récepteurs CPV (3) et aux au moins deux moyens de connexion électrique (4), de préférence dans lequel une brasure de résistance est utilisée pour former la chaine d'interconnexion (6).

13. Procédé selon la revendication 9, dans lequel l'assemblage des couches comprend, avant la réalisation de l'étape de durcissement,
la fixation des couches assemblées par le biais de trous de mise en place coïncidentes (9a, 9b, 9c, 9d) ;
le remplissage des évidements (11) dans les fenêtres (7a, 8a) depuis lesquelles font saillie les récepteurs CPV (3) avec un adhésif optique, pour former une couche adhésive optique (12) ;
la mise en place d'une optique secondaire (3d) dans lesdits évidements (11) sur ladite couche adhésive optique (12).

14. Système pour photovoltaïque sous concentration comprenant un panneau récepteur stratifié selon la revendication 1.

15. Installation pour fabriquer des panneaux récepteurs stratifiés selon la revendication 1 comprenant :
des moyens pour mettre en place une pluralité de récepteurs CPV (3) sur une plaque de base thermiquement conductrice (1) ;
des moyens pour former une première couche d'isolation (5) sur la plaque de base (1) ;
des moyens pour former une chaine d'interconnexion électrique (6) sur la première couche d'isolation (5) ;
des moyens pour former une seconde couche d'isolation (7) sur la première couche d'isolation (5) ;
des moyens pour former une feuille de protection (8) sur la seconde couche d'isolation (7) ; et
des moyens pour connecter la pluralité de récepteurs CPV (3) à l'aide de la chaine d'interconnexion électrique (6) ;
dans lequel la première couche d'isolation (5) est configurée pour permettre un bon contact thermique entre les récepteurs CPV (3) et la plaque de base (1) à l'aide d'une pluralité de fenêtres (5a) correspondant à la position et à la forme de la pluralité de récepteurs CPV (3), et
la seconde couche d'isolation (7) et la feuille de protection (8) sont configurées pour permettre au rayonnement solaire d'être concentré dans l'optique secondaire à ouverture solaire de récepteur CPV (3d), à l'aide d'une pluralité de fenêtres (7a, 8a) correspondant à la position et à la forme de l'optique secondaire (3d) de telle sorte que l'optique secondaire (3d) fait saillie depuis la feuille de protection (8).
